# EUROPEAN PATENT APPLICATION

(11) **EP 4 722 826 A1**
(43) Date of publication of application: **08.04.2026**
(21) Application number: 25205965.4
(22) Date of filing: 01.10.2025
(51) Int. Cl.: G05B 9/02, G01R 31/50, A61C 3/00, A62C 37/00, G08B 17/00, G08B 19/00, G08B 25/14, G08B 29/04

(54) **A SAFETY CONTROL SYSTEM AND A METHOD FOR OPERATING THE SAFETY CONTROL SYSTEM**

(30) Priority: 02.10.2024 US 202463702273 P; 02.10.2024 US 202463702328 P
(71) Applicant: IEP Technologies, LLC, Marlborough MA 01752 (US)
(72) Inventor: Yohman, Richard D., Canfield, 44406 (US); Minjarik, Ludovit, Brunswick, 44212 (US); Cirbus, Douglas, Charlton, 01507 (US); Bucci, Richard, New Brighton, 15066 (US); Karalis, Peter, Watertow, 02472 (US)
(74) Representative: Patentanwälte Pinter & Weiss OG

(57) **Abstract**

A safety control system with real-time diagnostic monitoring of a plurality of actuators (216, 218), each adapted to mitigate one or more safety events when actuated, comprises a D&A module (300) adapted to be in electric communication with an actuator circuit (240) comprising at least one actuator (216, 218) via an actuation circuit (230), the D&A module (300) having a resistance analyzer (238) adapted to measure an electrical resistance of the actuator circuit (240) connected to the actuation circuit (230), wherein the safety control system being adapted to determine whether the measured electrical resistance of the actuator circuit (240) aligns and/or falls within a predetermined range or predetermined threshold to determine a status of the actuator circuit (240), and wherein an interface (234) of the control system being adapted to display indicators (318, 418, 518, 618) relating to the status of the actuator circuit (240).

## Description

The present teachings relate generally to safety control systems for a facility and a method for operating the safety control system.

A control panel for safety and protection systems may receive and process data from a network of detectors. By monitoring the environment of the system based on inputs from detectors, the control panel may predict and/or detect an explosion based on, for example, data from the network of detectors indicating a rapid pressure increase or the presence of flames following a temperature increase.

The control panel may also send signals to a network of actuators which control the deployment of one or more actuators, like suppressors. The quantity, size, and type of suppressors are chosen based on, but not limited to, the protected vessel size, strength, and geometry, the material being handled, and process operating parameters.

Further, in manufacturing environments, particularly those handling combustible dust or flammable vapors, the risk of explosions caused by sparks is a significant concern. Sparks may be generated during various industrial processes, such as grinding, cutting, or material handling, often due to friction, static discharge, or equipment malfunction. If the sparks come into contact with airborne dust particles or flammable vapors, they may initiate an explosion, posing severe risks to both equipment and personnel.

Traditionally, within manufacturing environments, actuator fault detection equipment uses set, predetermined electrical resistance ranges to determine ground fault and short circuit conditions in actuator circuits. Conventionally, a simple indicator light mounted on the control panel signals the fault conditions. Actual measurement values for these faults are not displayed to a user or technician. Further, during the commissioning of the protection system or for trouble shooting, a field engineer conventionally must use a specialized low current multimeter to measure resistance in the actuator circuit.

Therefore, it would be beneficial to have an alternative system and method for an actuator diagnostic monitoring system.

The needs set forth herein as well as further and other needs and advantages are addressed by the present embodiments, which illustrate solutions and advantages described below.

One embodiment of a safety control system according to the present teachings includes, but is not limited to, a plurality of actuators, each adapted to mitigate one or more safety events (like a hazardous event) when actuated. A D&A module is adapted to be in electronic communication with an actuator circuit comprising at least one actuator via a actuation circuit 230. A resistance analyzer 238 of the D&A module 300 is adapted to measure an electrical resistance of the actuator circuit. The safety control system is adapted to determine whether the measured electrical resistance aligns and/or falls within a predetermined range or predetermined threshold to determine a status of the actuator circuit. An interface of the control system is adapted to display indicators relating to a status of the actuator circuit based on the measurement. This allows the real-time diagnostic monitoring of the status of the actuator circuit during operation. This does also facilitate commissioning and trouble shooting of the safety control system.

In an advantageous embodiment, the D&A module being adapted to determine whether the measured electrical resistance aligns and/or falls within the predetermined range or predetermined threshold to determine a status of the actuator circuit. In this connection, the D&A module can have the interface or a control panel is connected to the D&A module and the control panel having the interface is provided in the safety control system.

In an alternative embodiment, a control panel with the interface is provided in the safety control system and the control panel being adapted to determine whether the measured electrical resistance aligns and/or falls within the predetermined fault range or predetermined fault threshold to determine a status of the actuator circuit and to display the status at its interface. The control panel is connected to the D&A module via a communication connection, wherein the D&A module transmits the measured electrical resistance to the control panel (over the communication connection, wherein the control panel determines whether the measured electrical resistance aligns and/or falls within the predetermined fault range or predetermined fault threshold to determine the status of the actuator circuit, and wherein the control panel displays the indicators relating to the status at its interface. In such a configuration, a central control panel for all D&A modules can monitor the status of all actuator circuits in the facility protected by the safety control system.

In order to increase the flexibility of the safety control system, the predetermined range or predetermined threshold is adjustable via the interface.

Setting-up and installing the safety control system can be facilitated, if the D&A module being adapted to apply an electrical actuation voltage to the actuator circuit for triggering the actuators in the actuator circuit, said actuation voltage causes an electrical actuation current to flow over the actuator circuit and wherein a current limiting circuit is provided in the D&A module and arranged to limit the actuation current to a set nominal actuation current. In this case it can be ensured that the set actuation current is independent form the actuators in the actuation circuit.

In safety and protection systems, control system are often designed and installed specifically for particular detectors. Each detector is adapted to measure a value indicative of one or more safety event and each of the plurality of detectors sends an input signal associated with the measured value to the safety control system. Each control system may be configured to recognize and process data from a set of compatible detectors. These control systems are fine-tuned to meet the specific requirements and parameters of the detectors used. However, later models of detectors may send different input signals that the control systems is not designed or installed to handle correctly.

It would be beneficial to have an alternative system and method for a customizable detector input. This is achieved by a control system comrpising a memory having a set of ranges for each of the plurality of detector input signals, the set of ranges including a normal condition and an alarm condition, such that the safety control system triggers at least one of the plurality of actuators when an input signal is received that meets the associated alarm condition stored in the memory. A graphical user interface is adapted to accept user input for configuring an upper value and a lower value for each range in the set of ranges.

For a better understanding of the present embodiments, together with other and further aspects thereof, reference is made to the accompanying drawings and detailed description, and its scope will be pointed out in the appended claims.
FIG. 1 depicts a facility with explosion and spark protection according to one embodiment of the present teachings.
FIG. 2 depicts a D&A module and an actuator circuit in an active state, according to one embodiment of the present teachings.
FIG. 3 depicts the D&A moduleand the actuator circuit in an short circuit fault state, according to one embodiment of the present teachings.
FIG. 4 depicts the D&A module and the actuator circuit in an open circuit fault state, according to one embodiment of the present teachings.
FIG. 5 depicts the D&A module and the actuator circuit in a ground fault state, according to one embodiment of the present teachings.
FIG. 6 depicts a graphical user interface for displaying status indicators, according to one embodiment of the present teachings.
FIG. 7 depicts a method to detect actuator circuit resistance according to one embodiment of the present teachings.
FIG. 8 depicts electric circuitry to detect actuator circuit resistance in the D&A module.
FIG. 9 depicts an implementation of the control panel.
FIG. 10 depicts an implementation of a D&A module.
FIG. 11 depicts a display screen on a visual interface of the safety control system.
FIG. 12 depicts another display screen on a visual interface of the safety control system.
FIG. 13 depicts a display screen on a visual interface of the safety control system

The present teachings are described more fully hereinafter with reference to the accompanying drawings, in which the present embodiments are shown. The following description is presented for illustrative purposes only and the present teachings should not be limited to these embodiments. Any computer configuration and architecture satisfying the speed and interface requirements herein described may be suitable for implementing the system and method of the present embodiments.

In compliance with the statute, the present teachings have been described in language more or less specific as to structural and methodical features. It is to be understood, however, that the present teachings are not limited to the specific features shown and described, since the systems and methods herein disclosed comprise preferred forms of putting the present teachings into effect.

For purposes of explanation and not limitation, specific details are set forth such as particular architectures, interfaces, techniques, etc. in order to provide a thorough understanding. In other instances, detailed descriptions of well-known devices, circuits, and methods are omitted so as not to obscure the description with unnecessary detail.

A "computing system" may provide functionality for the present teachings. The computing system may include software executing on computer readable media that may be logically (but not necessarily physically) identified for particular functionality (e.g., functional modules). The computing system may include any number of computers/processors, which may communicate with each other over a network. The computing system may be in electronic communication with a datastore (e.g., database) that stores control and data information. Forms of computer readable media include, but are not limited to, disks, hard drives, random access memory, programmable read only memory, or any other medium from which a computer can read.

Generally, all terms used in the claims are to be interpreted according to their ordinary meaning in the technical field, unless explicitly defined otherwise herein. All references to a/an/the element, apparatus, component, means, step, etc. are to be interpreted openly as referring to at least one instance of the element, apparatus, component, step, etc., unless explicitly stated otherwise. The steps of any method disclosed herein do not have to be performed in the exact order disclosed, unless explicitly stated. The use of "first", "second," etc. for different features/components of the present disclosure are only intended to distinguish the features/components from other similar features/components and not to impart any order or hierarchy to the features/components.

Recitations of numerical ranges by endpoints include all numbers within that range (e.g., 1 to 5 includes 1, 1.5, 2, 2.75, 3, 3.80, 4, 5, etc.). Where a range of values is "greater than", "less than", etc., of a particular value, that value is included within the range.

Any direction referred to herein, such as "top," "bottom," "left," "right," "upper," "lower," "above," below," and other directions and orientations are described herein for clarity in reference to the figures and are not to be limiting of an actual device or system or use of the device or system. Many of the devices, articles, or systems described herein may be used in a number of directions and orientations.

Turning now to an overview of the present teaching, in various manufacturing plants the presence of flammable vapors, combustible dust, and/or hybrid mixture create a risk of a possible explosion. In this respect, safety systems are implemented to suppress or divert an explosion that is potentially created. In safety systems, a control system integrates real time sensors, detectors, automated response mechanisms, and user interfaces to manage the activation and coordination of actuators, suppression devices, and systems, for example, ensuring rapid containment of explosive events.

To implement a safety control system (e.g., for explosion and spark protection control), each detector (sensor) 212, 214 and actuator (suppressor) 216, 218 may be placed in communication with a detection and actuation module 300 (D&A module), which in turn may be in communication with a central control panel 200 via a data network to carry out the necessary controls for a facility 100. The detectors 212, 214 may detect an explosion in its early stages and provide a signal to the respective D&A module 300. The actuators 216, 218 may be connected to an actuation circuit 230 of a D&A module 300 and, upon detection of an explosion, receive a signal from the D&A module 300 to operate.

When a D&A module is generally addressed then the reference numeral 300 is used. When specific D&A modules are addressed then the different D&A modules are distinguished by adding lower case letters to the reference numeral 300. When a detector is generally addressed then the reference numeral 212, 214 is used. When specific detectors are addressed then the different detectors are distinguished by adding lower case letters to the reference numeral 212, 214. When an actuator is generally addressed then the reference numerals 216, 218 are used. When specific actuators are addressed then the different actuators are distinguished by adding lower case letters to the reference numerals 216, 218.

The control panel 200 provides an interface 234 for displaying information about the facility 100, like a status of certain parts of the facility, or for allowing configuration or parameterization of components of the safety system.

In some embodiments, actuators 216, 218, like suppressors, use an explosive or pyrotechnic actuator to initiate opening of a suppressor valve and/or an isolation valve. Each actuator 216, 218 may have two wires that are connected as actuator circuit 240 to the actuation circuit 230 in the D&A module 300. In instances where multiple actuators 216, 218 are used in an actuator circuit 240, the actuators 216, 218 of the actuator circuit 240 are electrically connected in series. The serially connected actuators 216, 218 are connected as actuator circuit 240 to the actuation circuit 230 of the D&A module 300. It should be understood that multiple parallel actuator circuits, each including one or multiple actuators 216, 218 arranged in series, may be connected to the D&A module 300. The D&A module 300 may have several actuation circuits 230, each for connecting to an actuator circuit 240. The D&A module 300 detects any erroneous state, like an open or short, in the actuator circuit 240. More specifically, the actuator circuit 240 is monitored by the D&A module 300 for an open circuit, a ground fault, or a short circuit by reading a resistance of the actuator circuit 240. When the actuator circuit 240 is functioning correctly and the safety system is active, the D&A module 300 is in an armed state. In case of a fault, like if an open circuit, ground fault, or short circuit occurs, the D&A module 300 provides a trouble signal, to be signaled to and displayed at the control panel 200, for example.

For triggering the at least one actuator 216, 218 in an actuator circuit 240 the actuation circuit 230 applies a given actuation voltage or actuation current to the actuator circuit 240, i.e. across or through the single or the serially connected multiple actuators 216, 218 in the actuator circuit 240. This causes an electrical current in dependence of the resistance of the actuator circuit 240 to flow over the actuators 216, 218, for example over the explosive or pyrotechnic actuator that triggers the actuators 216, 218, or a voltage drop across the actuator circuit 240.

Further, in some embodiments, the safety control system monitors and displays the status of the actuator circuit 240 in real time, without additional equipment such as specialized low current digital multimeters. In some embodiments, the measured resistance information can be used to troubleshoot actuator circuits 240 in real time and anticipate circuit faults. In some instances, changes in measured resistance in the actuator circuit 240 over time may indicate moisture infiltration of the actuator circuit 240. Additionally, in some embodiments, electrical resistance fault ranges are adjustable in the control panel 200.

Moreover, during commissioning of the disclosed safety control system, a field engineer need not use a specialized low current multimeter to measure the resistance of the actuator circuit 240. Thus, the disclosed safety control system eliminates the need for carrying special equipment, facilitates problem identification, and reduces the cost and time to commission and maintain an explosion protection system.

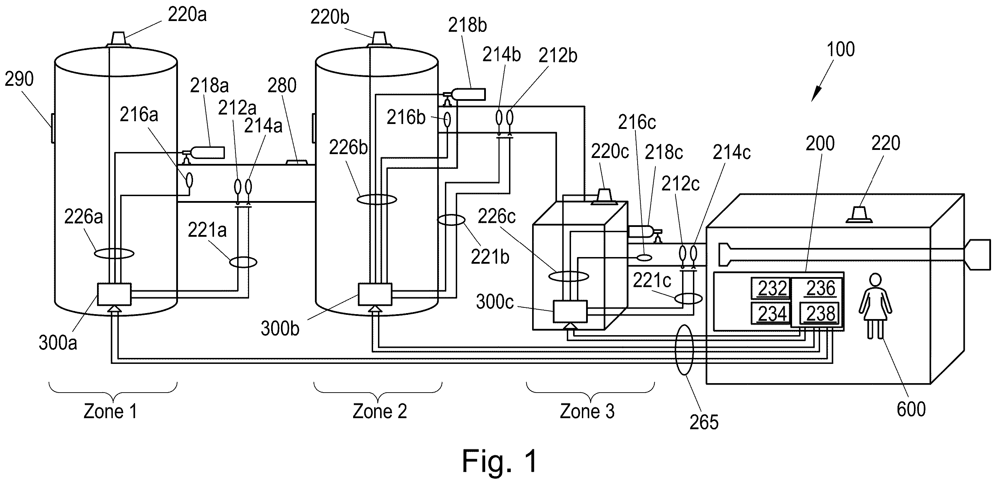

Referring now to the drawings, FIG. 1 illustrates a facility 100 having several zones of protection (labeled as Zone 1, Zone 2, and Zone 3 and referenced by a, b, c) with several detectors 212, 214 and actuators 216, 218 in each zone. For each zone, a D&A module 300 is provided that provides explosion and spark protection functionality to the respective zone. A person of ordinary skill in the art can appreciate how to designate and implement zones of protection for the facility 100 considering, for example, multiple parts of a single manufacturing line or multiple lines combined. Upon installation, a user 600 programs a control panel 200 to define the various zones of protection.

Various detectors 212, 214 are placed throughout the facility 100 to provide explosion and spark protection detection capabilities. For explosion suppression, as a non-limiting example, explosion detectors 214 (i.e., explosion sensors) are provided - explosion detector 214a for Zone 1, explosion detector 214b for Zone 2, and explosion detector 214c for Zone 3 in FIG.1. For spark extinguishing, as another non-limiting example, spark detectors 212 (i.e., spark sensors) are provided - spark detector 212a for Zone 1, spark detector 212b for Zone 2, and spark detector 212c for Zone 3 in FIG.1.

The explosion detectors 214 may include, but are not limited to, various acoustic, optical, and pressure sensors and gas and flame detectors. For example, a MEX-3^{™} Pressure Detector from IEP Technologies may be used. It should be noted that the same set of sensors do not have to be implemented within each zone of protection. Instead, each zone of protection may be assessed for possible explosion risks and detection sensors are installed accordingly.

The spark detectors 212 may include, but are not limited to, optical, infrared, fiber optic, electromagnetic, and acoustic sensors. For example, an Atexon^{®} SD300-EX or SDF300-EX Spark Detector from IEP Technologies may be used. It should be noted that the same set of sensors do not have to be implemented within each zone of protection.

Additionally, spark detectors 212 may be placed near or apart from explosion detectors 214 within the same or adjacent zones of the facility 100. For example, the spark detectors 212 may be placed upstream of a manufacturing process or vessel as the associated explosion detectors 214. Spark detectors 212 are usually placed on ductwork of the facility 100.

Various actuators 216, 218 may be placed throughout the facility 100 to provide safety protection (e.g., explosion and spark protection) capabilities. For explosion suppression, explosion suppression units are provided as actuators 218 - explosion suppression units as actuators 218a-218c for Zones 1-3 in the illustrated embodiment. For spark extinguishing, spark extinguishing units are provided as actuators 216 - spark extinguishing units as actuators 216a-216c for Zones 1-3 in the illustrated embodiment.

The explosion suppression units as actuators 218a-218c (i.e., explosion suppression responses) may include, but are not limited to, various electromechanical, hydraulic, pneumatic, pyrotechnic, and spring-loaded actuators. For example, an eSUPPRESSOR^{™} high-rate discharge suppressor or PistonFire II suppressor from IEP Technologies may be used with control panel 200. The present teachings include one or more explosion suppression units 218 for various zones of the facility. It should be noted that the same explosion suppression units as actuators 218 do not have to be implemented within each zone of protection. Instead, each zone of protection may be assessed for possible explosion risks and the explosion suppression units as actuators 218 are installed accordingly.

The spark extinguishing units as actuators 216a-216c (i.e., spark extinguishing responses) may include, but are not limited to, various electromechanical, hydraulic, pneumatic, pyrotechnic, and spring-loaded actuators. For example, a EXT11, EXT12, or EXT22 extinguishing units from IEP Technologies that spray a small amount of water - extinguishing the hazard without damaging facility 100 equipment - may be used. The present teaching may include one or more spark extinguishing units as actuators 216 for various zones or detection areas of the facility 100. The user 600 of the control panel 200 has the option to control and implement one or more protection zones. It should be noted that the same spark extinguishing units as actuators 216 do not have to be implemented within each zone of protection.

In some facilities 100, it may be advantageous to isolate an explosion or vent an explosion rather than suppress it. An explosion isolation valve 280 or an exhaust vent 290 may be used alongside or in place of explosion suppression unit as actuators 216. A person skilled in the art will appreciate the considerations for using a combination of these.

The D&A modules 300 of the explosion and spark control system of the facility 100 are connected to the detectors 212, 214 and the actuators 216, 218 within its assigned zone. Rather than direct connections from each detector and actuator 212-218 to the control panel 200, each zone includes a detection and actuation module 300 (D&A module) about the area of detection - D&A module 300a for Zone 1, D&A module 300b for Zone 2, and D&A module 300c for Zone 3.

The control panel 200 may handle between one zone and eight zones, although not limited thereto. It may handle 1, 2, 3, 4, 5, 6, 7, 8, 9, 10, 11, 12, 13, 14, 15, 16, 17, 18, 19, 20, 25, 30, etc. zones. To enable such configurability (and more), at least one detection and actuation module 300 may be used. 1, 2, 3, 4, 5, 6, 7, 8, 9, 10, 11, 12, 13, 14, 15, 16, 17, 18, 19, 20, 25, 30, etc. modules may be used. For example, four detection and actuation modules 300 may be used in combination with the control panel 200 to handle eight zones. The detection and actuation module 300 combines inputs and outputs from across the facility 100 for easier installation and maintenance. The control panel 200 may handle any number of zones and can be connected to any number of D&A modules 300 which combine inputs and outputs from across facility 100 for easier installation and maintenance.

Detectors 212, 214, like detectors 212a-212c, 214a-214c in FIG. 1, may be electrically coupled to respective D&A modules 300a-300c by input connections 221a-221c (i.e., input sensor cables). Alternatively, one or more of the detectors 212, 214 for the various zones may be connected in series or in parallel with one another before being coupled to the D&A module 300 by the input connections 221. Usually there is at least one detector 212, 214 connected to each D&A module 300.

When an input connection is generally addressed then the reference numeral 221 is used. When a specific input connection is addressed then the different input connections are distinguished by adding lower case letters to the reference numeral 221.

Actuators 216, 218, like actuators 216a-216c, 218a-218c may be electrically coupled to respective D&A modules 300a-300c by output connections 226a-226c (i.e., actuator cables). Each D&A module 300 may include two phases, the first phase being the detection phase involving input sensors such as heat, smoke, flame, or pressure detectors. If the system confirms a hazardous event, the second phase, being the actuation, may be triggered to respond to the threat.

When an output connection is generally addressed then the reference numeral 226 is used. When a specific output connection is addressed then the different output connections are distinguished by adding lower case letters to the reference numeral 226.

Each of the plurality of D&A modules 300a-300c may contain an alarm system 220a-220c for displaying the zone status. The alarm system 220a-220c communicates with the control panel 200.

The input connections 221a-221c and the output connection 226a-226c may be a first type of wire. In some embodiments, the first type of wire is, for example, but not limited to, copper wiring or other suitable wiring that transmits one signal between a detector 212, 214 or actuator 216, 218 and the corresponding D&A module 300.

Between each of the plurality of D&A modules 300 and the control panel 200 may be a second type of wire for a communication connection 265. In some embodiments, the second type of wire is, for example, but not limited to, Ethernet wiring or other suitable wiring that transmits multiple signals between the D&A module 300a and the control panel 200.

The D&A module 300 may include an actuation circuit 230, a memory 232, an interface 234, and a processor 236, like a CPU or computer system. The processor 236 contains instructions to execute a resistance analyzer 238. As will be explained in greater detail below, the resistance analyzer 238 measures and analyzes actual, real-time resistances related to the actuator circuit 240 with the actuators 216, 218 connected to the D&A module 300 via the actuation circuit 230.

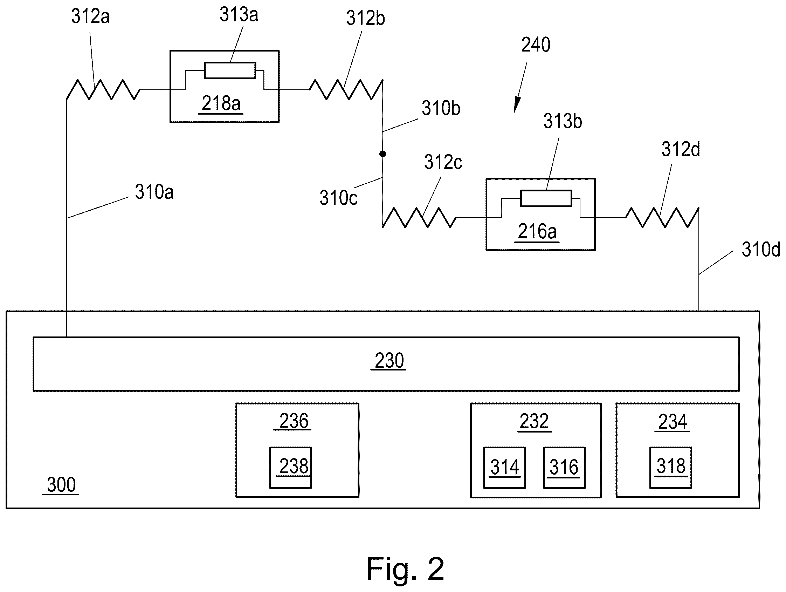

FIG. 2 schematically illustrates the D&A module 300 and actuators 216a, 218a in an actuator circuit 240 of the facility 100 in an active state. The actuators 216a, 218a are in electrical communication with the actuation circuit 230 of the D&A module 300. Further, the actuators 216a, 218a are electrically in series with one another.

More specifically, the actuator 218a may have a first wire 310a and a second wire 310b. Similarly, the actuator 216a may include a third wire 310c and a fourth wire 310d. The first wire 310a and the fourth wire 310d are in electrical communication with the actuation circuit 230. Further, the second wire 310b is in electrical communication with the third wire 310c, i.e. the second wire 310b is electrically connected to the third wire 310c. Thus, the actuators 216a, 218a are electrically in series.

Each of the actuators 216a, 218a has a resistance 313a, 313b that is known from the known type of actuator 216a, 218a used.

Each of the first, second, third, and fourth wires 310a-d may respectively have a first, second, third, and fourth resistance 312a-d, which are an inherent material property of the wires 310a-d. The resistances of the wires 310a-d are usually very small as compared to the resistances of the actuators 218 and, hence, are usually ignored.

In some embodiments, additional resistors of known resistance values may be electrically placed along the wires 310a-d.

Therefore, the actuator circuit 240 has an overall electrical resistance value comprised of the resistances 312a-d of wires 310a-d and the resistances 313a, 313b of actuators 216a, 218a.

In operation, the processor 236 executes the resistance analyzer 238 to monitor and measure actual, real-time resistance values of the actuator circuit 240.

Further, the resistance analyzer 238 may analyze and compare the measured resistance values to resistance fault ranges 314 and/or resistance fault thresholds 316 retrieved from the memory 232. When the measured resistance values align and/or fall within the stored resistance fault ranges 314 and /or resistance fault thresholds 316, the interface 234 shows an active status indicator 318 (e.g., "OK," "active," "armed," etc.).

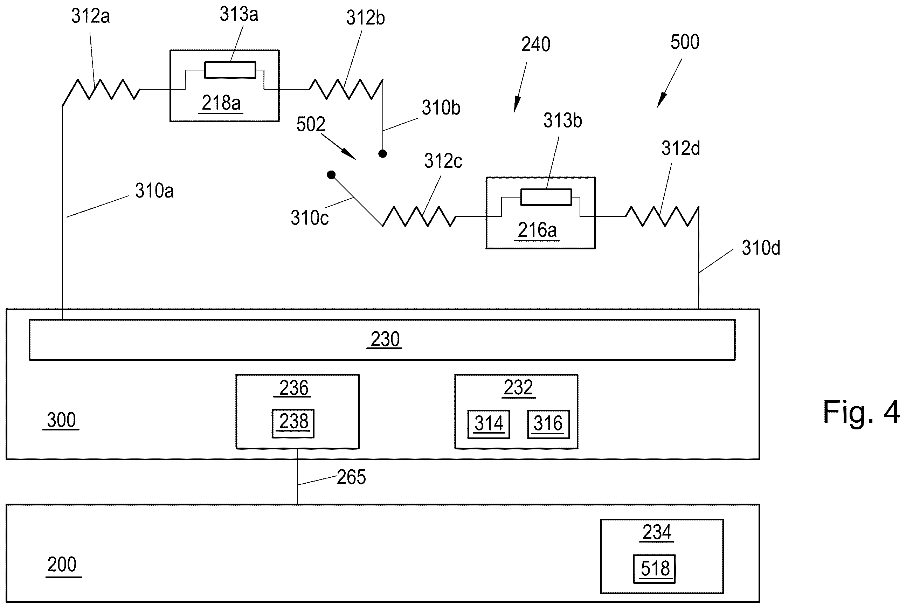

In another embodiment, the interface 234 is in the control panel 200 and the D&A module 300 signals the status of the actuator circuit 240 to the control panel 200 via the communication connection 265 where the status (e.g., "OK," "active," "armed," etc.) is shown at the interface 234. This embodiment is shown in FIG. 4.

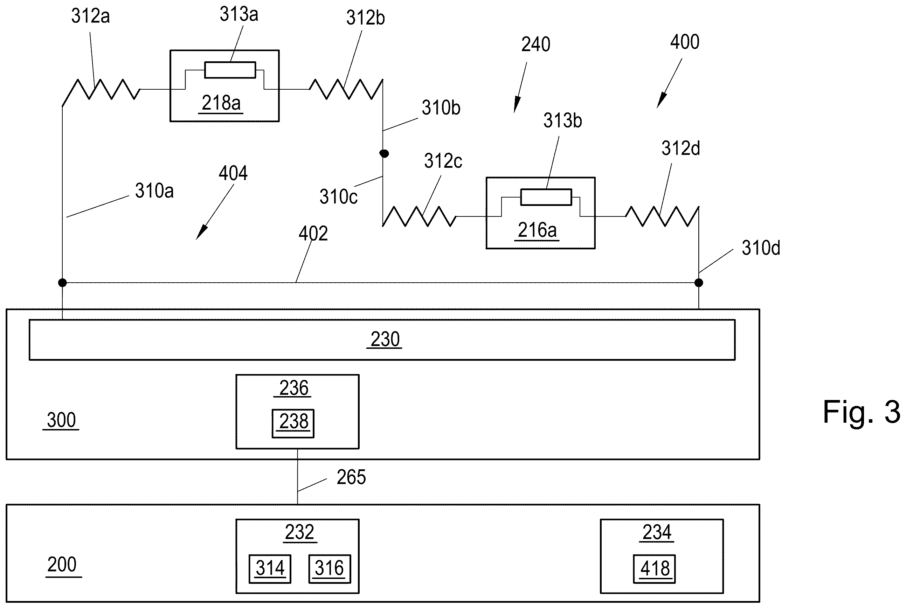

In yet another, preferred, embodiment, the resistance analyzer 238 of the D&A module 300 only determines the resistance of the actuator circuit 240 and transmits the measured resistance to the control panel 200 via the communication connection 265. The control panel 200 may analyze and compare the measured resistance values to resistance fault ranges 314 and/or resistance fault thresholds 316 retrieved from the memory 232 of the control panel 200. In this case, the control panel 200 comprises a processor, like a CPU or computer system, that contains instructions to analyze actual, real-time resistances related to the actuator circuits 240. When the measured resistance values align and/or fall within the stored resistance fault ranges 314 and/or resistance fault thresholds 316, the interface 234 of the control panel 200 shows an active status indicator 318 (e.g., "OK," "active," "armed," etc.). This embodiment is shown in FIG. 3.

The resistance of the actuator circuit 240 may be determined with the resistance analyzer 238 by using a constant current source in the actuation circuit 230 with an electrical current set at well below the required power level to set off the actuators 216a, 218a in the actuator circuit 240, like a pyrotechnic actuator. This ensures that measuring the resistance does not unintentionally trigger the actuators 216a, 218a. On a periodic basis a path is provided from the constant current source in the actuation circuit 230 through the connected actuators 216a, 218a of the actuator circuit 240, by means of a transistor (MOSFET), for example. A voltage drop is developed across the actuator circuit 240 (with the actuators 216a, 218a and field wiring with wires 310) that is measured in the resistance analyzer 238, for example by means of an Instrumentation Amplifier and an A/D converter of a resistance analyzer 238. The resistance analyzer 238 uses the voltage measured across the actuator circuit 240 and the known current to calculate the resistance value. The value is then compared to adjustable setpoints of ranges - one low, one high - to determine if the actuator circuit 240 is within the required resistance range. If the predetermined actuator circuit 240 resistance values are outside of the expected range, a trouble condition may be signaled and indicated on the interface 234.

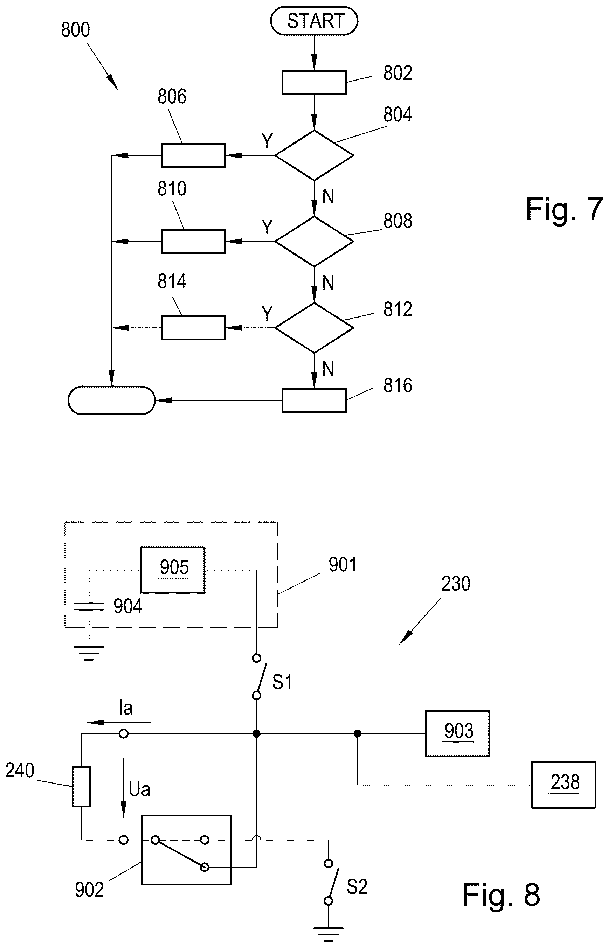

FIG. 8 shows a possible implementation of the actuation circuit 230 and the resistance analyzer 238. In the actuation circuit 230 an electrical power supply 901, provides the electrical energy for triggering the actuators 216a, 218a of the actuator circuit 240. The electrical power supply 901 may comprise a tank capacitor 904 for storing electrical energy. A relay 902 is used to arm the actuator circuit 240. In the state of the relay 902 shown, both output terminals of the actuator circuit 240 are connected to the same electrical potential and the actuator circuit 240 is disarmed. In the other state of the relay 902 (in FIG.8 indicated with dashed line), the actuator circuit 240 is armed. In the armed state the voltage of the tank capacitor 904 is applied to the actuator circuit 240 when switch S1, like a transistor, is closed which triggers the actuators 216a, 218a in the actuator circuit 240. For measuring the resistance of the actuator circuit 240, actuator circuit 240 is armed and switch S1 is open. The current of a constant current source 903 is applied to the actuator circuit 240 by closing switch S2, like a transistor. The generated voltage drop across the actuator circuit 240 is measured by the resistance analyzer 238.

FIG. 3 schematically illustrates the control panel 200, a D&A module 300 and an actuator circuit 240 with serially connected actuators 216a, 218a of the facility 100 in a fault state, in this case a short circuit state 400. As above, the actuator circuit 240 is in electrical communication with the actuation circuit 230. More specifically, as above, the first wire 310a and the fourth wire 310d are in electrical communication with the actuation circuit 230. Further, the second wire 310b is in electrical communication with the third wire 310c.

Additionally, in the short circuit state 400, a conductive path 402 (e.g., a loose wire, water with dissolved electrolytes, loose solder, dust, etc.) forms a short circuit 404 electrically between the first wire 310a and the fourth wire 310d, or also between any other pair of electrical conductors in the actuator circuit 240. In the illustrated example of FIG. 3, the conductive path 402 directly electrically links the first wire 310a and the fourth wire 310d. It should be understood that electrically placing the conductive path 402 in various alternative configurations along the first, second, third, and fourth wires 310a-d may also produce the short circuit 404.

In operation, the processor 236 executes the resistance analyzer 238 to monitor and measure the actual, real-time resistance values of the actuator circuit 240. In the embodiment of FIG. 3 the control panel 200 analyzes and compares the measured actual, real-time resistance values of the actuator circuit 240 to the resistance fault ranges 314 and/or the resistance fault thresholds 316. The control panel 200 determines whether the measured resistance values align and/or fall within the stored resistance fault ranges 314 and /or resistance fault thresholds 316. Further, the control panel 200 determines whether the measured resistance values are caused by and/or are indicative of a short circuit (e.g., the short circuit 404).

If the measured resistance values do not align and/or fall outside the stored resistance fault ranges 314 and /or resistance fault thresholds 316, and/or the measured resistance values are caused by and/or are indicative of a short circuit, the control panel 200instructs the interface 234 on the control panel 200 to display a short circuit status indicator 418 (e.g., "short," "trouble," "error," etc.).

FIG. 4 schematically illustrates the control panel 200, a D&A module 300 and an actuator circuit 240 with serial connected actuators 216a, 218a of the facility 100 in another fault state, like in an open circuit state 500. In the open circuit state 500, one or more openings 502 are present within the actuator circuit 240, like in an actuator 216a, 218a and/or along the field wiring (wires 310), i.e. the first, second, third, and fourth wires 310a-d. In the illustrated example of FIG. 4, the second wire 310b is disconnected from the third wire 310c, thus producing the opening 502. In the example of FIG. 4, the actuator circuit 240 remains in electrical communication with the actuation circuit 230 via the first wire 310a and the fourth wire 310d.

It should be understood that electrically forming one or more openings 502 in various alternative configurations along the actuators 216, 218 and the first, second, third, and fourth wires 310a-d may also produce the open circuit state 500.

In operation, as above, the processor 236 executes the resistance analyzer 238 to monitor and measure the actual, real-time resistance values of the actuator circuit 240. In the embodiment of FIG. 4 the resistance analyzer 238 analyzes and compares the resistance values to the resistance fault ranges 314 and/or the resistance fault thresholds 316. The resistance analyzer 238 determines whether the measured resistance values align and/or fall within the stored resistance fault ranges 314 and /or resistance fault thresholds 316. Further, the resistance analyzer 238 determines whether the measured resistance values are indicative of an open circuit (e.g., the open circuit state 500).

If the measured resistance values do not align and/or fall outside the stored resistance fault ranges 314 and /or resistance fault thresholds 316, and/or the measured resistance values are indicative of an open circuit, the D&A module 300, like the resistance analyzer 238 in the D&A module 300, signals the status, here the open state 500, to the control panel 200 via the communication connection 265 where the status is displayed at the interface 234 as an open circuit status indicator 518 (e.g., "open," "trouble," "error," etc.).

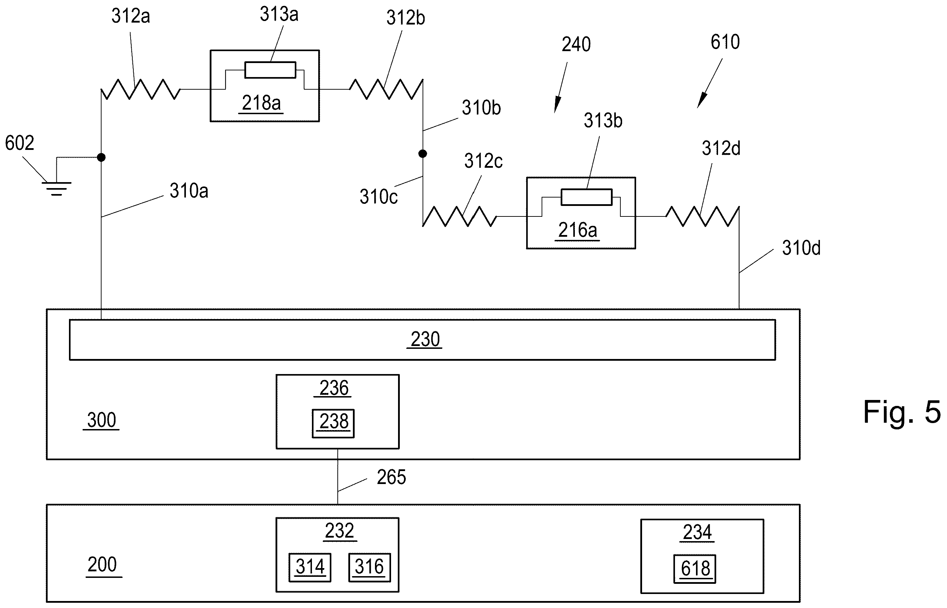

FIG. 5 schematically illustrates the control panel 200, a D&A module 300 and an actuator circuit 240 with serial connected actuators 216a, 218a of the facility 100 in another fault state, like in a ground fault state 610. In the ground fault state 610, one or more of the actuators 216a, 218a and/or the field wiring, like the first, second, third, and fourth wires 310a-d, are in electrical communication with a ground 602. In the illustrated example of FIG. 5, the first wire 310a is electrically connected to the ground 602. In the example of FIG. 5, the second wire 310b is electrically connected to the third wire 310c and the actuator circuit 240 remains in electrical communication with the actuation circuit 302 via the first wire 310a and the fourth wire 310d.

It should be understood that electrically connecting the ground 602 in various alternative configurations along the actuators 216a, 218a and the first, second, third, and fourth wires 310a-d may also produce the ground fault state 610.

In operation, as above, the processor 236 executes the resistance analyzer 238 to monitor and measure the actual, real-time resistance values of the resistance of the actuator circuit 240. In the embodiment of FIG. 5, the resistance analyzer 238 analyzes and compares the resistance values to the resistance fault ranges 314 and/or the resistance fault thresholds 316 stored in the memory 232. The resistance analyzer 238 determines whether the measured resistance values align and/or fall within the stored resistance fault ranges 314 and /or resistance fault thresholds 316. Further, the resistance analyzer 238 determines whether the measured resistance values are indicative of a ground fault state 610

If the measured resistance values do not align and/or fall outside the stored resistance fault ranges 314 and /or resistance fault thresholds 316, and/or the measured resistance values are indicative of a ground fault, the D&A module 300, like the resistance analyzer 238, signals the status, here the ground state 610, to the control panel 200 via the communication connection 265 where the status is displayed at the interface 234 as a ground fault status indicator 618 (e.g., "open," "trouble," "error," etc.).

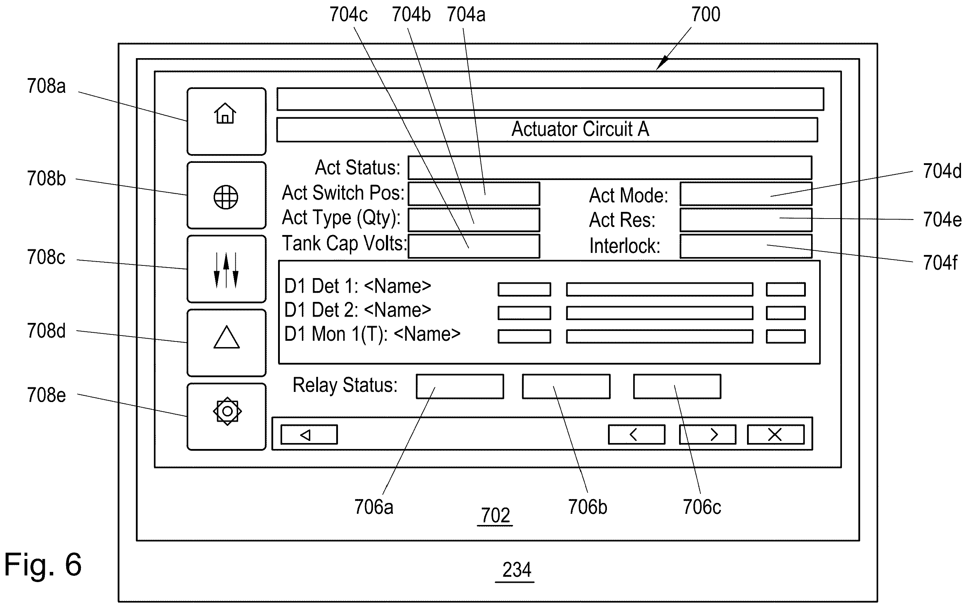

FIG. 6 depicts a graphical user interface 700 displayable via a display 702 of the interface 234, preferably in the control panel 200. In some embodiments, the display 702 is a touchscreen. The graphical user interface 700 may include a plurality of actuator status indicators 704a-f, a plurality of relay status indicators 706a-c, a home graphical button 708a, a system graphical button 708b, a configuration graphical button 708c, a log graphical button 708d, and a maintenance graphical button 708e.

More specifically, the actuator status indicator 704e shows the measured overall, actual, real-time resistance of the actuator circuit 240 (shown in FIG. 2). Additionally, a user may selectively click on the configuration graphical button 708c to adjust the resistance fault ranges 314 and the resistance fault thresholds 316 of a specific actuator circuit 240. In an embodiment in which the D&A module 300 compares the measured resistance values of the actuator circuit 240 to the resistance fault ranges 314 and/or the resistance fault thresholds 316, the control panel 200 may transmit the configured resistance fault ranges 314 and the resistance fault thresholds 316 to the respective D&A module 300.

In addition to actuator resistance monitoring the tank capacitor 904 voltage may be monitored in a D&A module 300 with low and high setpoints that may be configured in the control panel 200, in the graphical user interface 700, for example. The tank capacitor 904 voltage may be displayed in a tank cap voltage indicator 704c of the graphical user interface 700. If the tank capacitor 904 voltage is out of range the respective D&A module 300 and/or the complete safety control system can be configured to go into a trouble condition, which may also be displayed in the interface 234.

The state of a relay 902 to arm or disarm the actuator circuit 240 may be displayed in a relay status indicator 706a, 706b, 706c of the graphical user interface 700.

There may be a graphical user interface 700 for each actuator circuit 240 in the facility 100.

FIG. 7 illustrates a method 800 executable by the safety control system of FIGS. 1 and 2 to determine electrical faults in actuator circuits 240 with actuators 216, 218. The method 800 begins at block 802, where the D&A module 300 monitors resistance of an actuator circuit 240 connected to the D&A module 300. More specifically, the actuation circuit 230 of the D&A module 300 measures actual, real-time resistance of the actuator circuit 240. The measured resistance value is transmitted to the control panel 200. The method 800 proceeds to block 804.

At block 804, the control panel 200 determines whether the measured resistance indicates a short circuit. More specifically, the control panel 200 determines whether the measured resistance indicates a short circuit of the actuator circuit 240 as compared to the resistance fault ranges 314 and/or resistance fault thresholds 316 retrieved from the memory 232.

**If,** at block 804, the control panel 200 determines that the measured resistance indicates a short circuit, the method proceeds to block 806.

**If,** at block 804, the control panel 200 determines that the measured resistance does not indicate a short circuit, the method proceeds to block 808.

At block 806, the control panel 200 displays a short circuit indicator 418. More specifically, the control panel 200 instructs the interface 234 to show the short circuit indicator 418. The method 800 returns to block 802.

At block 808, the control panel 200 determines whether the measured resistance indicates an open circuit of the actuator circuit 240. More specifically, the control panel 200 determines whether the measured resistance indicates an open circuit as compared to the resistance fault ranges 314 and/or resistance fault thresholds 316 retrieved from the memory 232.

If, at block 808, the control panel 200 determines that the measured resistance indicates an open circuit, the method proceeds to block 810.

If, at block 808, the control panel 200 determines that the measured resistance does not indicate an open circuit, the method proceeds to block 812.

At block 810, the control panel 200 displays an open circuit indicator 518. More specifically, the control panel 200 instructs the interface 234 to show the open circuit indicator 518. The method 800 returns to block 802.

At block 812, the control panel 200 determines whether the measured resistance indicates a ground fault of the actuator circuit 240. More specifically, the control panel 200 determines whether the measured resistance indicates a ground fault as compared to the resistance fault ranges 314 and/or resistance fault thresholds 316 retrieved from the memory 232.

If, at block 812, the control panel 200 determines that the measured resistance indicates a ground fault, the method proceeds to block 814.

If, at block 812, the control panel 200 determines that the measured resistance does not indicates a ground fault, the method proceeds to block 816.

At block 814, the control panel 200 displays a ground fault indicator 618. More specifically, the control panel 200 instructs the interface 234 to show the ground fault indicator 618. The method 800 returns to block 802.

At block 816 the control panel 200 displays an active circuit indicator 318 of the actuator circuit 240. More specifically, the control panel 200 instructs the interface 234 to show the active circuit indicator 318. The method 800 returns to block 802.

As already mentioned above, actuator 216, 218, like pyrotechnic actuators to initiate opening of a suppressor valve and/or an isolation valve, are typically electrically connected in series to form an actuator circuit 240. Each actuator 216, 218 has a certain resistance that may be different between different actuator types and manufactures. Typical resistance values of an actuator 216, 218 are from 0.5 to 2 Ω, specifically 0.8 to 1.6 Ω. Any number from 1 to 20, or even more, actuators 216, 218 can be connected to an actuator circuit 240.

For triggering the actuators 216, 218 in an actuator circuit 240, an electric actuation voltage Ua is applied to the actuator circuit 240 by the actuation circuit 230. Depending on the total resistance of the actuator circuit 240, which in turn depends on the number and types of actuator 216, 218 in the actuator circuit 240, applying the actuation voltage Ua causes a certain electrical actuation current la to flow in the actuator circuit 240 (as is shown in FIG. 8). Many actuators 216, 218, especially pyrotechnic actuators, have the problem that they do not fire when the actuation current is too low. On the other hand, they also do not fire, when the actuation current la is too high. In case of an excessive current, it may happen that the firing of one or more pyrotechnic actuators creates an open condition of the actuation circuit 240 preventing subsequent actuators from firing.

The prior method to handle this was to insert a series current limiting resistor of typically 10 Ω in the actuator circuit 240 when a smaller number of actuator 216, 218 are used (typically under 8) to limit the current to the actuators 216, 218. When the number of actuators 216, 218 used was greater than 8 the current limit resistor was not inserted or removed from the series circuit. This required quite some effort to properly install a safety system, especially the actuator circuit 240. Apart from that it was difficult to change the configuration of the actuator circuit 240.

To mitigate this, the actuation circuit 230 may use a current limiting circuit 905 that limits the actuation current la to a set nominal current, like nominally 3.5 A, independent of an actual resistance of the of the actuator circuit 240. The current limiting circuit 905 may be implemented as constant current source with a depletion mode MOSFET having a feedback resistor between source and gate that adjusts the current to the required current value.

With the current limiting circuit 905, the current limit to the actuators 216, 218 is automatic and there is no need any longer to manually insert a current limiting resistor in the actuation circuit 240.

In the embodiment of FIG. 8 circuitry for detecting the resistance value of the actuator circuit 240 and for limiting the actuation current la is implemented. However, it is of course possible to either implement only the circuitry for detecting the resistance value of the actuator circuit 240 or the circuitry for limiting the actuation current Ia.

Control systems known in the art have predefined ranges (defined by thresholds) for input signals for detectors 212, 214. Those ranges are generally unchangeable. Control systems with predefined ranges are thus limited to only using the same detectors 212, 214 from installation.

Detectors 212, 214 generate as input signal an electrical voltage or electrical current or resistance. With respective set ranges, the input signal delivered by a detector 212, 214 is then "translated" into a certain state of the facility 100 in the area of the detector 212, 214. In an embodiment, specific resistance, voltage and/or current values from the detectors 212, 214 determine if the detector 212, 214 is in an "OK" condition, "Trouble Low" condition, "Trouble High" condition or in an "Alarm" condition. When the input signal is within the alarm range it tells the control system for example that an incipient explosion has occurred which in turn sends a signal to the connected actuators 216, 218 in the zone of the detector 212, 214 for triggering the actuators 216, 21 and to isolate the explosion in that zone.

According to an embodiment of the invention, the setpoints of the ranges of the input signals (both low and high for each range) of a detector 212, 214 can be adjusted, preferably for each detector 212, 214, as described below.

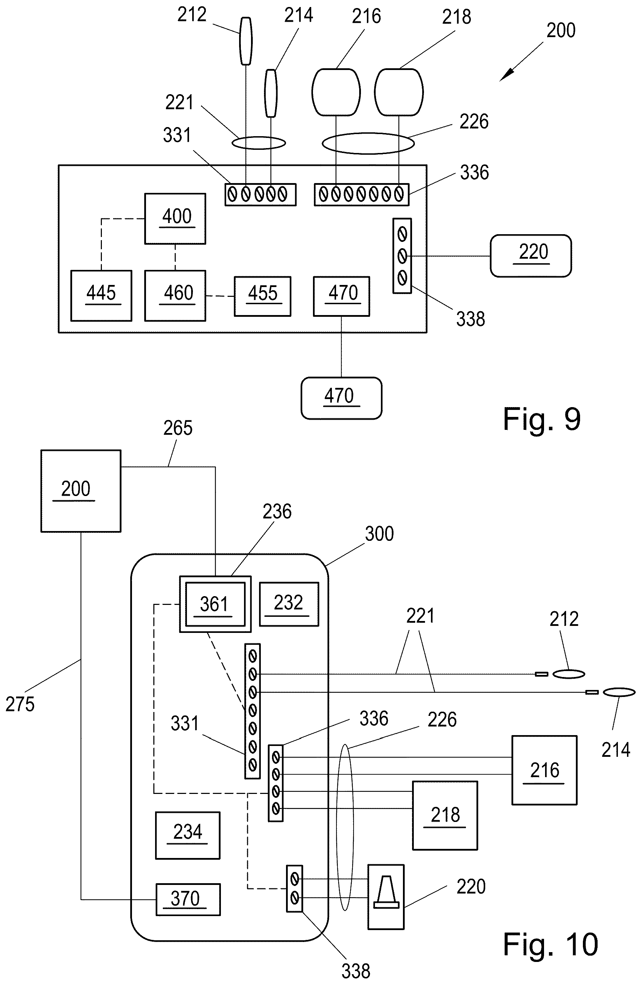

FIG. 9 illustrates an embodiment of a control system for explosion and spark protection control according to one embodiment of the present teachings. A control panel 200 may comprise a processing unit 400 (i.e., a central processing unit or CPU), a communication module 460 with a visual interface 455 (i.e., a graphical user interface or GUI), and a memory 445 (i.e., a datastore), although not limited thereto. The processing unit 440 of the control panel 200 may be capable of executing program instructions, performing arithmetic, logical, control, and input/output operations.

The processing unit 440 may be, but is not limited to, a controller, processor, multiprocessor, microcontroller, or another suitable programmable device or computing system.

The control panel 200 may contain an input terminal 331 and an output terminal 336. A plurality of detectors 212, 214 are electrically coupled to the input terminal 331 via input connections 221. A plurality of actuators 216, 218 are electrically coupled to the output terminal 336 via output connections 226. An alarm system 220 may be electrically coupled to an alarm terminal 338.

In some embodiments of the control system, terminals 331 and 336, and possibly also 338, are organized into one or more detection and actuation (D&A) modules 300, which may be installed in the same housing as the control panel 200 or remotely with electrical communication between the one or more D&A modules 300 and the control panel 200 (as described above with reference to FIG. 1 and as shown in FIG. 10). In such an embodiment, electrical power can be transmitted from the control panel 200 to a power module 370 of the D&A module 300 via a power connection 275.

The memory 445 of the control panel 200 stores and manages data such as associated values from the detectors 212, 214 (i.e., input sensors). The memory 445 retains programmed settings and process the associated values received from the detectors 212, 214 and may store historical data for diagnostics of the control system for a facility 100. Historical data may include records of past detectors readings, system states, and events.

The memory 445 includes, for example, a program storage area and a data storage area. The program storage area and the data storage area may include combinations of different types of memory, such as read-only memory ("ROM"), random access memory ("RAM"), electrically erasable programmable read-only memory ("EEPROM"), flash memory, a hard disk, an SD card, or other suitable magnetic, optical, physical, or electronic memory devices. The processing unit 440 is connected to the memory 445 and may execute software instructions that are capable of being stored in a RAM of the memory 445 or another non-transitory computer readable medium such as another memory or a disc. Software included in the implementation of the control panel 200 can be stored in the memory 245. The software includes, for example, firmware, one or more applications, program data, filters, rules, one or more program modules, and other executable instructions. The processing unit 200 is configured to retrieve from memory 445 and execute, among other things, instructions related to the control processes and methods described herein.

In one embodiment, input data from the detectors 212, 214 is stored in the memory 445 of the control panel 200 in non-volatile memory and may be stored indefinitely until it is overwritten or that location in memory 445 is erased. In another embodiment, for example, input data from the detectors 212, 214 may be stored in a similar memory 232 of one or more D&A modules 300 in addition to, or in place of, the memory 445 of the control panel 200. In yet another embodiment, for example, certain input data from the detectors 212, 214 indicative of notable events (e.g., an alarm condition or a trouble condition) are stored in an event log in the memory 445 that includes input data alongside additional data for context, such as, but not limited to, alarms, warning, system on/off or resets, arming/disarming the control panel 200.

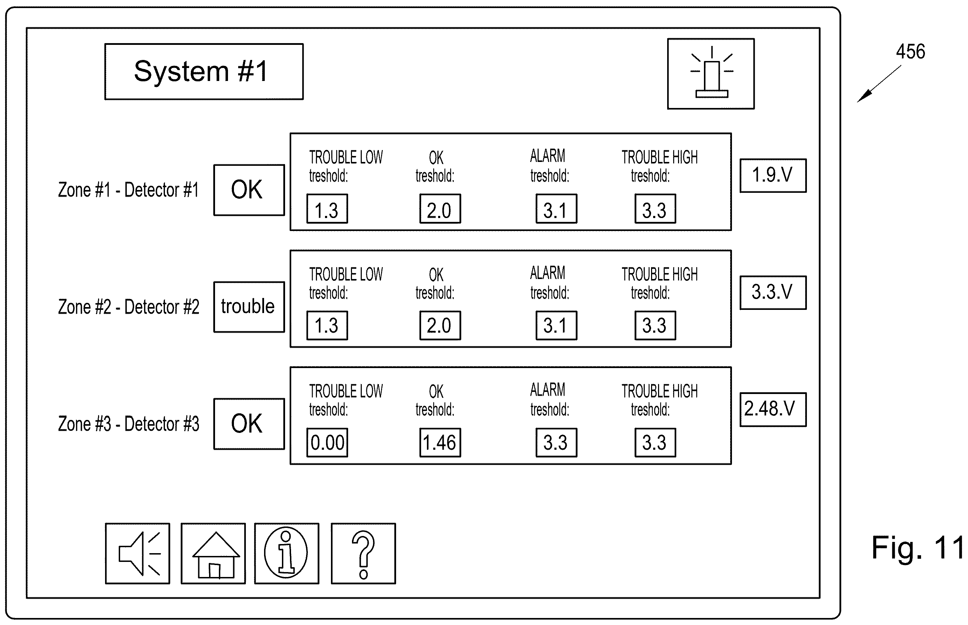

Further, the communication module 460 of the control panel 200 may comprise a visual interface 455 wherein the visual interface 455 may consist of a display screen 456. The display screen 456 - described in further detail with respect to FIGS. 11, 12 and 13 below - may include a plurality of graphical symbols including text and numerical values capable of displaying a variety of visual representations known in the art. The communication module 460 may display information from the memory 445, the processing unit 440, and/or the detectors 212, 214 and actuators 216, 218 to the user 600.

In one embodiment, the visual interface 455 is a touch screen accessible on a housing of the control panel 200. In another embodiment, the visual interface 455 is displayed on an external device, for example a field laptop or cellular phone, via a wired connection between the communication module 460 and the external device. In yet another embodiment, the visual interface 455 is displayed on the external device via a wireless connection between the communication module 460 and the external device. The wired connection may be, for example, but not limited to, a HDMI port and cable, a USB port and cable, or others known in the art.

In another embodiment, the control panel 200 may be connected via a wired connection (e.g., ethernet) of the communication module 460 to a programmable logic controller (i.e., PLC) used elsewhere in a facility to monitor and control a process. The visual interface 455 may be displayed at the PLC or related human machine interface (i.e., HMI).

The control panel further comprises a power module 470 electrically coupled to a power source - AC, DC, 12V, 24V, or others known in the art - or backup power such as a battery in case of power failure.

FIGS. 11, 12 and 13 depict display screens 456 for customizing detector inputs in several embodiments of the present teachings.

The display screen 456 in FIG. 11 visually displays input signals from three detectors 212, 214 in three different zones of the facility 100 (labeled Zone #1 - Detector #1, Zone #2 - Detector #2, and Zone #3 - Detector #3). Each of the Detectors has a TROUBLE LOW condition (i.e., a low condition), an OK condition (i.e., a normal condition), an ALARM condition, and a TROUBLE HIGH condition (i.e., a high condition). Each of the conditions is defined as a corresponding range between a lower value and an upper value (i.e., a lower threshold and an upper threshold) of the input signal. In some embodiments, the upper value for one condition or range may also be the lower value for another condition or range that is adjacent or subsequent numerically.

For example, the TROUBLE LOW range may be between the lower value of 0 volts and the upper value of a TROUBLE LOW threshold, the OK range is between the lower value of the TROUBLE LOW threshold and the upper value of the OK threshold, the ALARM range is between the lower value of the OK threshold and the upper value of the ALARM threshold, and the TROUBLE HIGH range is greater than the TROUBLE HIGH threshold (i.e., between the lower value of the TROUBLE HIGH threshold and the upper value of 10 volts).

In the illustrative example, the value of inputs signals from the Detectors #1-#3 (i.e., input sensors 212, 214) are displayed on the righthand side of the display screen 456, with an indication of the comparison to the ranges on the lefthand side of the display screen 456. Detectors #1 and #3 are in the OK range while Detector #2 is in the TROUBLE HIGH range. In some embodiments, an input signal in the low condition or range is indicative of a short circuit for the related detector 212, 214 and an input signal in the high condition range is indicative of an open circuit for the related detector 212, 214.

Between the input signal value and the indication are a series of text boxes. A user can select each of the series of text boxes on the visual interface 455 (i.e., a graphical user interface or GUI). In one embodiment, the user 600 inputs a new threshold by selecting a value from a drop-down menu in the text box. In another embodiment, the user 600 inputs a new threshold by typing a value in the text box.

The OK range for Detectors #1-3 may, for example, start at preset 0 volts and 1 volt. Then a user may adjust the OK-TROUBLE threshold by 0.01 volt increments and, for example, set the Detector #1 OK range to be 0 to 1.3 volts, the Detector #2 OK range to be 0 to 1.46 volts, and the Detector #3 range to have yet a different OK-TROUBLE threshold.

In some embodiments, a user can set two of the sets of thresholds to the same value and thus reduce the number of ranges. In the illustrative example, Detector #3 has the ALARM threshold and the TROUBLE HIGH threshold both input (i.e., selected) to 3.3 V. Thus, Detector #3 may modified from having four conditions and related ranges - TROUBLE LOW, OK, ALARM, and TROUBLE HIGH - to three ranges - TROUBLE LOW, OK, and ALARM.

It can be appreciated that, based on the present teachings, the control panel 200 with visual interface 455 for receiving user inputs to adjust ranges for comparison to the input signals from detectors 212, 214 can be reconfigured to work with different detectors without replacing the control panel 200 or components thereof. New detectors with different ranges of detection, improved precision, or improved accuracy can be used with the control panel 200. In one embodiment, for example, a user may be able to select a profile from the memory 445 that includes one or more ranges and conditions for types of detectors 212, 214 (e.g., an infrared sensor or a pressure sensor) and then further customize associated values of the one or more ranges on the display screen 456.

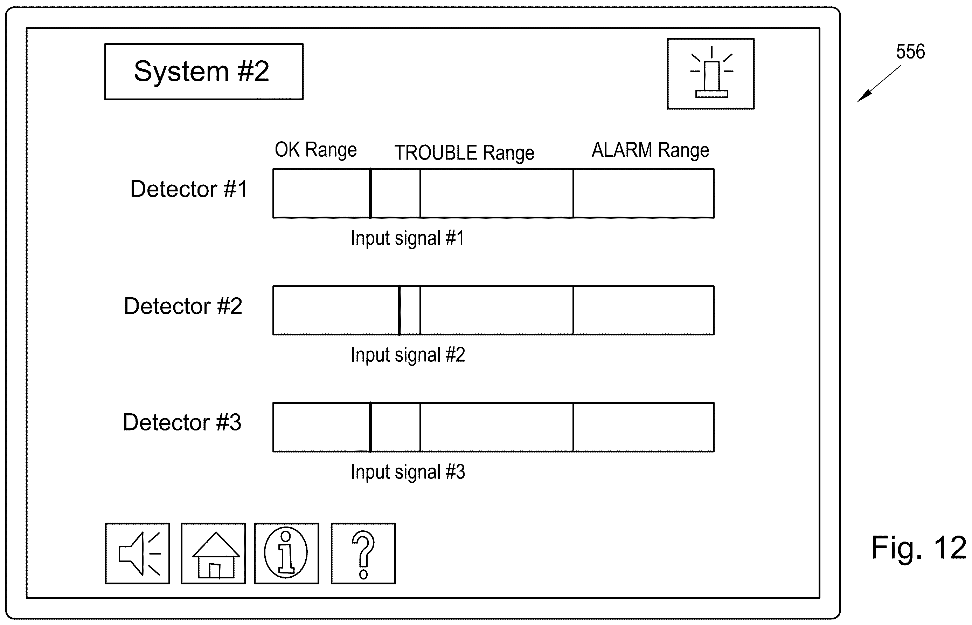

According to another embodiment in FIG. 12, the visual interface 455 of the communication module 460 of the control panel 200 is a display screen 456. The display screen 456 may be a touch screen on or near the housing of the control panel 200 or a screen displayed on an external device via a wired or wireless connection between the control panel 200 and the external device.

The display screen 456 visually displays input signals from three detectors 212, 214 (labeled Detector #1, Detector #2, and Detector #3) and an OK range, TROUBLE range, and an ALARM range for each on a horizontal bar. In the illustrative example, all three input signals are in the OK range which indicates the control panel 200 does not send any output signals to the actuators 216, 218 to cause an explosion suppression or spark extinguishing response.

Each of the horizontal bars in the illustrative example has 2 threshold values between the ranges - an OK-TROUBLE threshold and a TROUBLE-ALARM threshold. In this example, the OK range is between 0 volts and the OK-TROUBLE threshold, and the ALARM range is above the TROUBLE-ALARM threshold.

In another embodiment, the OK range is between the TROUBLE range and the ALARM range. In yet another embodiment, there are two TROUBLE ranges - TROUBLE LOW range and TROUBLE HIGH range - with the TROUBLE LOW range and the ALARM range, and the ALARM range between the OK range and the TROUBLE HIGH range. It can be appreciated that other combinations and arrangements of ranges and conditions are possible to suit the characteristics of the detectors 212, 214.

Each of the horizontal bars can be manipulated by the user 600 to adjust at least one of the OK range, the TROUBLE range, or the ALARM range (or its respective thresholds). The user 600 may move the vertical lines - representing the OK-TROUBLE threshold and TROUBLE-ALARM threshold - via a touch screen or click of a mouse button, although not limited thereto.

The OK range for Detectors #1-3 (i.e., input sensors 212, 214) may, for example, start at preset 0 volts and 1 volt. Then the user 600 may adjust the OK-TROUBLE threshold by 0.01 volt increments and, for example, set the Detector #1 OK range to be 0 to 1.3 volts, the Detector #2 OK range to be 0 to 1.46 volts, and the Detector #3 range to have yet a different OK-TROUBLE threshold. It can be appreciated by one skilled in the art that similar adjustments can be made with user input to each Detector's TROUBLE range and ALARM range by manipulated other thresholds on the display screen 456.

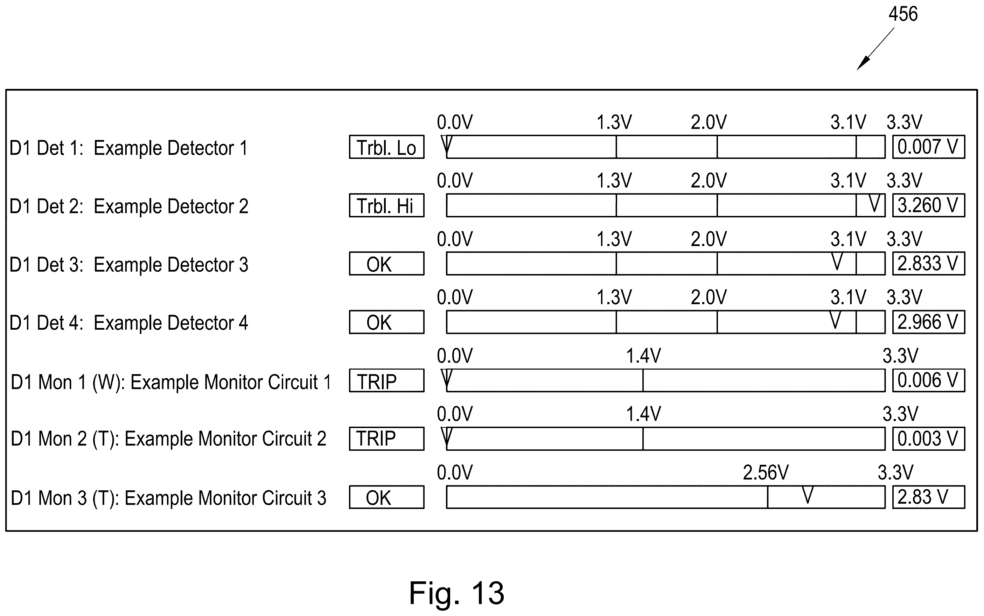

According to another embodiment in FIG. 13, the visual interface 455 of the communication module 460 of the control panel 200 is a display screen 456. The display screen 456 displays a plurality of detectors (Example Detector 1 to 4 and Example Monitor Circuit 1 to 3) including a plurality of ranges and values for various conditions. All of the detectors displayed may be associated with, for example, one zone in a facility and one associated actuator. Each of the horizontal bars can be manipulated by a user via the visual interface 455 to adjust at least one of the OK range, the TROUBLE range, or the ALARM range. The manipulation may be, for example, by entering a value in a text box (on the same image or a pop-up image), selecting a value from a drop-down list, or touching and dragging portions of the horizontal bar. The user may move the vertical lines - representing the OK-TROUBLE threshold and TROUBLE-ALARM threshold - via a touch screen or click of a mouse button, although not limited thereto.

Additionally, after the lower values and upper values of each of the ranges or conditions are input by a user 600, the detectors 212, 214 are displayed on the visual interface 455 as shown in FIG. 13. Similar to the ranges illustrated within FIG. 11 and 12, FIG. 13 illustrates multiple detectors with input signals in a variety of ranges. Example Detector 1 is producing a voltage classified in the TROUBLE LOW range. This may indicate a short circuit and the control panel 200 will notify a user using, for example, the alarm system 200 but does not send any output signals to the actuators 216, 218 to cause an explosion suppression or spark extinguishing response. Example Detector 2 is producing a voltage classified in the TROUBLE HIGH range. This may indicate an open circuit and the control panel 200 will notify a user using, for example, the alarm system 220 but does not send any output signals to the actuators 216, 218 to cause an explosion suppression or spark extinguishing response.

Both Example Detectors 3 and 4 and Example Monitor Circuit 3 (which may consist of several detectors 212, 214 sending a combined signal to the control panel 200) are producing a voltage within the OK range (i.e., the normal range or normal condition). In the OK range, no alarm is made via the alarm system 220. If any of the Example Detectors 1-4 or Example Monitor Circuits 1-3 were in the ALARM condition or range, then the control panel 200, or the respective D&A module 300, would send an output signal to the actuators 216, 218 to cause an explosion suppression or spark extinguishing response.

In some embodiments, the control panel 200 may have more detectors 212, 214 in a given zone that can be displayed at one time on the display screen 456, in which case a user may scroll - using, for example, a touch, mouse, or keyboard - to view additional detector inputs and associated conditions and ranges on the display screen 456.

All thresholds of the ranges of a detector 212, 214, preferably of all detectors 212, 214, are stored in the memory 445 of the control panel 200 and/or in the memory 232 of the respective D&A module 300.

In some embodiments, the control panel 200 may determine that a new detector 212, 214 has been added to the safety system due to the presence of a new input signal, and the display screen 456 may prompt a user 600 to input values for associated ranges for the normal, alarm, and/or trouble conditions for the new detector 212, 214, that are then stored for the new detector 212, 214. In another embodiment, the control panel 200 may determine that a detector 212, 214 has been replaced because of a change in the input signal that is not quite indicative of an alarm or trouble condition, and the display screen 456 may prompt a user 600 to adjust values for associated ranges for the normal, alarm, and/or trouble conditions for the replacement detector 212, 214, that are then stored for the replacement detector 212, 214.

In a preferred embodiment, the ranges (or thresholds of the ranges) for a detector 212, 214, for the normal, alarm, and/or trouble conditions, for example, may be configured (adjusted or set) via a display screen 456 of the control panel 200. The control panel 200 may send the configured ranges for the detector 212, 214 to the respective D&A module 300 the detector 212, 214 is connected to and the configured ranges for the detector 212, 214 are stored in the memory of the D&A module 300. The D&A module 300 determines the state of the detector 212, 214 by comparing input signals of the detector 212, 214 to the stored ranges and triggers an actuator 216, 218 connected to the D&A module 300 in case of a detected incipient explosion or spark (e.g. when an ALARM condition is determined).

The ability to change the OK, TROUBLE, and ALARM conditions by changing ranges of input signals, and related values, of detectors 212, 214 without replacing the control panel 200 or its components may be valuable for the interoperability of the control panel 200 with many types of detectors 212, 214 and improvements to the same.

While the present teachings have been described above in terms of specific embodiments, it is to be understood that they are not limited to these disclosed embodiments. Many modifications and other embodiments will come to mind to those skilled in the art to which this pertains, and which are intended to be and are covered by both this disclosure and the appended claims. It is intended that the scope of the present teachings should be determined by proper interpretation and construction of the appended claims and their legal equivalents, as understood by those of skill in the art relying upon the disclosure in this specification and the attached drawings.

## Claims

1. A safety control system comprising
a plurality of actuators (216, 218), each adapted to mitigate one or more safety events when actuated;
a D&A module (300) adapted to be in electric communication with an actuator circuit (240) comprising at least one actuator (216, 218) via an actuation circuit (230), the D&A module (300) having a resistance analyzer (238) adapted to measure an electrical resistance of the actuator circuit (240) connected to the actuation circuit (230);
the safety control system being adapted to determine whether the measured electrical resistance of the actuator circuit (240) aligns and/or falls within a predetermined range or predetermined threshold to determine a status of the actuator circuit (240);
an interface (234) of the control system being adapted to display indicators (318, 418, 518, 618) relating to the status of the actuator circuit (240).

2. The system of claim 1, wherein the D&A module (300) being adapted to determine whether the measured electrical resistance aligns and/or falls within the predetermined range or predetermined threshold to determine a status of the actuator circuit (240).

3. The system of claim 2, wherein the D&A module (300) having the interface (234) or a control panel (200) is connected to the D&A module (300) and the control panel (200) having the interface (200) is provided in the safety control system.

4. The system of claim 1, wherein a control panel (200) with the interface (234) is provided in the safety control system and the control panel (200) being adapted to determine whether the measured electrical resistance aligns and/or falls within the predetermined fault range or predetermined fault threshold to determine a status of the actuator circuit (240) and to display the status at its interface (234).

5. The system of any of claims 1 to 4, wherein the status comprises one of a plurality of states of the actuator circuit (240) including an active state, a short circuit state, an open circuit state, and a ground fault state.

6. The system of any of claims 1 to 5, wherein the predetermined range or predetermined threshold is adjustable via the interface (234).

7. The system of any of claims 1 to 6, wherein the actuator circuit (240) comprises a plurality of actuators (216, 218) that are electrical in series with one another.

8. The system of any of claims 1 to 7, wherein the D&A module (300) being adapted to apply an electrical actuation voltage (Ua) to the actuator circuit via the actuation circuit (230) for triggering the actuators (216, 218) in the actuator circuit (240), said actuation voltage (Ua) causes an electrical actuation current (la) to flow over the actuator circuit (240) and wherein a current limiting circuit (905) is provided in the D&A module (300) and arranged to limit the actuation current (Ia) to a set nominal actuation current.

9. The system of any of claims 1 to 8, additionally comprising
a plurality of detectors (212, 214), each adapted to measure a value indicative of one or more safety event;
each of the plurality of detectors (212, 214) send an input signal associated with the measured value to the safety control system;
a memory (232, 445) having a set of ranges for each of the plurality of detector input signals, the set of ranges including a normal condition and an alarm condition, such that the safety control system triggers at least one of the plurality of actuators (216, 218) when an input signal is received that meets the associated alarm condition stored in the memory (232, 445); a graphical user interface (445) adapted to accept user input for configuring an upper value and a lower value for each range in the set of ranges.

10. The system of claim 9, wherein the set of ranges including a trouble high condition and a trouble low condition, such that the safety control system generates an alert when an input signal is received that meets the trouble high condition and/or the trouble low condition.

11. The system of claim 9 or 10, wherein the safety control system is adapted to identify a new detector (212, 214) based at least in part on its input signal being outside of one or more of its associated ranges.

12. The system of any of claims 9 to 11, wherein at least one of the plurality of detectors (212, 214) is connected to the D&A module (300) via an input connection (221) and at least one of the plurality of actuators (216, 218) is connected to the D&A module (300) via an output connection (226), wherein the D&A module (300) comprises a memory (232) for storing the set of ranges for the input signal of the connected at least one of the plurality of detectors (212, 214) and wherein the D&A module (300) triggers the connected at least one of the plurality of actuators (216, 218) when an input signal is received from the connected at least one of the plurality of detectors (212, 214) that meets the associated alarm condition stored in the memory (232).

13. The system of any of claims 9 to 12, wherein a control panel (200) is provided in the safety control system and the control panel (200) provides the graphical user interface (445).

14. The system of claim 12 and 13, wherein the D&A module (300) is connected to the control panel (200) via a communication connection (265) and the control panel (200) being provided to send the configured upper value and a lower value for a detector (212, 214) connected to the D&A module (300) over the communication connection (265).

15. A method for operating a safety control system comprising a plurality of actuators (216, 218), each adapted to mitigate one or more safety events when actuated, the method comprising the steps of
measuring an electrical resistance of an actuator circuit (240) having at least one actuator (216, 218) and being connected to an actuation circuit (230) of a D&A module (300) with a resistance analyzer (238) of the D&A module (300);
determining, by the safety control system, whether the measured electrical resistance of the actuator circuit (240) aligns and/or falls within a predetermined range or predetermined threshold to determine a status of the actuator circuit (240);
displaying indicators (318, 418, 518, 618) relating to the status of the actuator circuit (240) on an interface (234) of the control system.

16. The method of claim 15, wherein the D&A module (300) determines whether the measured electrical resistance aligns and/or falls within the predetermined range or predetermined threshold to determine the status of the actuator circuit (240).

17. The method of claim 16, wherein the D&A module (300) comprises the interface (234) and displays the indicators (318, 418, 518, 618) relating to the status at its interface (234).

18. The method of claim 16, wherein the D&A module (300) transmits the status of the actuator circuit (240) to a control panel (200) connected to the D&A module (300) via a communication connection (265) and wherein the control panel (200) comprises the interface (234) and displays the indicators (318, 418, 518, 618) relating to the status at its interface (234).

19. The method of claim 15, wherein a control panel (200) with the interface (234) is provided in the safety control system and the control panel (200) is connected to the D&A module (300) via a communication connection (265), wherein the D&A module (300) transmits the measured electrical resistance to the control panel (200) over the communication connection (265), wherein the control panel (200) determines whether the measured electrical resistance aligns and/or falls within the predetermined fault range or predetermined fault threshold to determine the status of the actuator circuit (240), and wherein the control panel (200) displays the indicators (318, 418, 518, 618) relating to the status at its interface (234).

20. The method of any of claims 15 to 19, wherein the predetermined range or predetermined threshold is adjustable via the interface (234).

21. The method of any of claims 15 to 20, wherein the D&A module (300) applies an electrical actuation voltage (Ua) to the actuator circuit (240) via the actuation circuit (230) for triggering the actuators (216, 218) in the actuator circuit (240), said actuation voltage (Ua) causes an electrical actuation current (la) to flow over the actuator circuit (240) and wherein a current limiting circuit (905) in the D&A module (300) limits the actuation current (la) to a set nominal actuation current.

22. The method of any of claims 15 to 21, additionally comprising the steps of
providing a plurality of detectors (212, 214), each adapted to measure a value indicative of one or more safety event, in the safety control system;
sending an input signal associated with the measured value to the safety control system by each of the plurality of detectors (212, 214);
storing a set of ranges for each of the plurality of detector input signals in a memory (232, 445), the set of ranges including a normal condition and an alarm condition, such that the safety control system triggers at least one of the plurality of actuators (216, 218) when an input signal is received that meets the associated alarm condition stored in the memory;
configuring an upper value and a lower value for each range in the set of ranges on a graphical user interface (445) adapted to accept user input.
